# EUROPÄISCHE PATENTSCHRIFT

(11) **EP 2 882 091 B1**
(45) Veröffentlichungstag und Bekanntmachung des Hinweises auf die Patenterteilung: **29.08.2018**
(21) Anmeldenummer: 14004041.1
(22) Anmeldetag: 01.12.2014
(51) Int. Cl.: H02N 2/10, H02N 2/00, H01L 41/09, H02N 2/14

(54) **Ultraschallmotor und Verfahren zum Betreiben eines solchen Ultraschallmotors**
Ultrasonic motor and method for operating such a ultrasonic motor
Moteur à ultrason et procédé de fonctionnement d'un tel moteur à ultrason

(30) Priorität: 29.11.2013 DE 102013224569
(43) Veröffentlichungstag der Anmeldung: 10.06.2015
(73) Patentinhaber: Physik Instrumente (PI) GmbH & Co. KG, 76228 Karlsruhe (DE)
(72) Erfinder: Wischnewskiy, Wladimir, 14712 Rathenow (DE); Wischnewski, Alexej, 76744 Wörth (DE)
(74) Vertreter: Schatt, Markus F.

(56) Entgegenhaltungen:
- DE-B3-102012 201 863
- JP-A- H0 638 558
- US-A1- 2006 145 572
- US-A1- 2010 156 239

## Beschreibung

Die Erfindung betrifft einen Ultraschallmotor nach den Ansprüchen 1 bis 5 und ein Verfahren zum Betreiben eines solchen Ultraschallmotors nach den Ansprüchen 6 bis 8. Die JP H06 38558 A offenbart einen Motor mit einer ringförmigen Elektrodenplatte und einer zweiten ringförmigen Elektrodenplatte, die aixal übereinander gelegen sind. Weiterhin weist der Motor zwei ringförmige piezoelektrische Elemente auf. Das piezoelektrische Element ist zwischen den beiden Elektrodenplatten angeordnet. Die erste Elektrodenplatte ist aus mehreren Erreger-Plattenteilen und Verbindungsabschnitten gebildet. Die zweite Elektrodenplatte dient als gemeinsame Elektrode.
Aus der US 7,218,031 B2 ist ein Ultraschallmotor mit einem piezoelektrischen hohlzylindrischen Aktor bekannt, bei dem an wenigstens einer der ebenen Stirnflächen eine Friktionsschicht oder mehrere Friktionselemente angeordnet sind, welche in Friktionskontakt mit einem rotatorisch anzutreibenden Element (Rotor) stehen. Gemäß Fig. 16 dieser Druckschrift können auch an beiden ebenen Stirnflächen des Aktors Friktionselemente angeordnet sein. Beim Verfahren zum Betreiben dieses Ultraschallmotors wird durch elektrische Erregung des Aktors dieser in eine gekoppelte tangential-axiale Schwingungsmode versetzt, wobei sich die entsprechenden Schwingungen auf die Friktionsschicht bzw. Friktionsschichten oder auf die Friktionselemente übertragen, so dass letztlich ein Antrieb des Rotors bzw. der Rotoren resultiert.
Im Falle, dass bei dem aus der US 7,218,031 B2 bekannten Ultraschallmotor zwei Rotoren in Friktionskontakt mit den Friktionsschichten bzw. den Friktionselementen an den gegenüberliegenden Stirnflächen des Aktors stehen, ist es hierbei lediglich möglich, beide Rotoren synchron anzutreiben. Ein unabhängiger Antrieb der beiden an den gegenüberliegenden Stirnflächen des Ultraschallaktors angeordneten Rotoren hingegen ist nicht möglich.

Aufgabe der vorliegenden Erfindung ist es daher, ausgehend von dem zuvor beschriebenen Stand der Technik einen Ultraschallmotor bereitzustellen, welcher es anhand eines nur einzigen hohlzylindrischen Ultraschallaktors ermöglicht, zwei anzutreibende Elemente unabhängig voneinander durch diesen zu bewegen.

Die Lösung der Aufgabe der Erfindung erfolgt durch einen Ultraschallmotor gemäß Anspruch 1, wobei die sich daran anschließenden Unteransprüche mindestens zweckmäßige Ausgestaltungen und Weiterbildungen umfassen.

Demnach wird von einem Ultraschallmotor mit einem hohlzylindrischen oder ringförmigem Ultraschallaktor aus einem piezoelektrischen Material ausgegangen, an dessen einer ebenen Stirnfläche eine erste Gruppe von Friktionselementen angeordnet ist, wobei die Friktionselemente der ersten Gruppe jeweils um einen ersten Umfangswinkel voneinander beabstandet sind und mit einem ersten anzutreibenden Element in Friktionskontakt stehen, und an dessen anderer ebenen Stirnfläche eine zweite Gruppe von Friktionselementen angeordnet ist, wobei die Friktionselemente der zweiten Gruppe jeweils um einen zweiten Umfangswinkel voneinander beabstandet sind und mit einem zweiten anzutreibenden Element in Friktionskontakt stehen, und an dessen Innenumfangsfläche eine allgemeine Elektrode angeordnet ist und an dessen Außenumfangsfläche Erregerelektroden angeordnet sind, wobei jede Erregerelektrode mit der allgemeinen Elektrode und dem zwischen ihnen angeordneten piezoelektrischen Material einen Generator für eine akustische Stehwelle ausbildet, und die Generatoren mit einer elektrischen Spannung beaufschlagbar sind, um in dem Ultraschallaktor eine akustische Stehwelle zu erzeugen. Erfindungswesentlich ist hierbei, dass die Friktionselemente der ersten Gruppe um einen dritten Umfangswinkel versetzt zu den Friktionselementen der zweiten Gruppe angeordnet sind, wobei der dritte Umfangswinkel kleiner als der erste Umfangswinkel und kleiner als der zweite Umfangswinkel ist.

Der Ultraschallaktor hat die geometrische Form eines Hohlzylinders mit einer bestimmten Wanddicke in radialer Richtung und einer Höhe h in axialer Richtung, wobei sich die Wanddicke bestimmt aus dem radialen Abstand zwischen der Außenumfangsfläche und der Innenumfangsfläche des Hohlzylinders. Während die Außenumfangsfläche und die Innenumfangsfläche gekrümmte Flächen sind, besitzt der Hohlzylinder auch zwei ebene Flächen, die den Hohlzylinder bezüglich seiner Höhe H in axialer Richtung begrenzen. Hierbei handelt es sich um ebene Stirnflächen des Hohlzylinders, die im Wesentlichen parallel zueinander verlaufen.

An jeder der beiden Stirnflächen sind mehrere Friktionselemente in Umfangsrichtung beabstandet zueinander angeordnet, wobei die jeweils benachbarten Friktionselemente um einen Winkel entlang des Umfangs des Ultraschallaktors (Umfangswinkel) voneinander beabstandet sind. Allerdings sind die Positionen bezogen auf den Umfang, an welchen die Friktionselemente angeordnet sind (Umfangspositionen), für die Friktionselemente der ersten Gruppe und für die Friktionselemente der zweiten Gruppe unterschiedlich. Mit anderen Worten befinden sich die Friktionselemente der zweiten Gruppe an anderen Umfangspositionen als die Friktionselemente der ersten Gruppe, so dass ein Winkelversatz zwischen diesen besteht. Der entsprechende Umfangswinkel ist hierbei kleiner als der Umfangswinkel, um den die Friktionselemente der ersten Gruppe und der zweiten Gruppe voneinander beabstandet sind.

Die spezielle Anordnung der Friktionselemente auf den beiden Stirnflächen des Ultraschallaktors ermöglicht es aufgrund einer geeigneten Ausbildung der in dem Ultraschallaktor angeregten oder erzeugten akustischen Stehwelle, dass nur das erste anzutreibende Element in Bewegung versetzt wird, während das zweite anzutreibende Element stillsteht, bzw. das nur das zweite anzutreibende Element in Bewegung versetzt wird, während das erste anzutreibende Element stillsteht. Durch entsprechenden Phasenversatz der akustischen Stehwelle ist es hierbei auch möglich, die Antriebsrichtung des jeweils anzutreibenden Elements zu ändern. Es sind also Bewegungen des anzutreibenden Elements in eine Richtung, wie auch in dazu entgegengesetzte Richtung möglich.

Es kann von Vorteil sein, dass der erste Umfangswinkel dem zweiten Umfangswinkel entspricht.

Es kann ebenso von Vorteil sein, dass der dritte Umfangswinkel einem Viertel des ersten Umfangswinkels oder einem Viertel des zweiten Umfangswinkels entspricht.

Weiterhin kann es von Vorteil sein, dass die Generatoren jeweils eine Vielzahl von sich abwechselnden Schichten von Erregerelektroden und allgemeinen Elektroden aufweisen, wobei zwischen zwei benachbarten Elektrodenschichten eines Generators eine Schicht piezoelektrischen Materials angeordnet ist. Hierdurch wird eine Ansteuerung der Generatoren mit einer geringeren elektrischen Spannung ermöglicht.

Zudem kann es von Vorteil sein, dass sowohl das erste anzutreibende Element, als auch das zweite anzutreibende Element in eine rotative Bewegung versetzbar sind, und der Masseschwerpunkt des ersten anzutreibenden Elements und des zweiten anzutreibenden Elements mit der jeweiligen Rotationsachse zusammenfällt. Die rotatorische Bewegung der beiden anzutreibenden Elemente ist hierbei besonders einfach realisierbar. Vorteilhaft kann hierbei sein, dass die Rotationsachse des ersten anzutreibenden Elements mit der Rotationsachse des zweiten anzutreibenden Elements zusammenfällt.

Die Erfindung betrifft zudem ein Verfahren zum Betreiben des Ultraschallmotors nach einer der vorhergehenden Ausführungsformen bzw. Weiterbildungen, wobei das Verfahren gekennzeichnet ist durch das Anlegen einer elektrischen Spannung an die Elektroden der Generatoren zur Erzeugung einer ersten akustischen Stehwelle mit longitudinaler und transversaler Schwingungskomponente in dem Ultraschallaktor, wobei die erste akustische Stehwelle derart ausgebildet ist, dass nur die Friktionselemente der ersten Gruppe das erste anzutreibende Element in eine Bewegung versetzen und ohne dass die Friktionselemente der zweiten Gruppe das zweite anzutreibende Element in eine Bewegung versetzen, oder Anlegen einer elektrischen Spannung an die Elektroden der Generatoren zur Erzeugung einer zweiten akustischen Stehwelle mit longitudinaler und transversaler Schwingungskomponente in dem Ultraschallaktor, wobei die zweite akustische Stehwelle derart ausgebildet ist, dass nur die Friktionselemente der zweiten Gruppe das zweite anzutreibende Element in eine Bewegung versetzen und ohne dass die Friktionselemente der ersten Gruppe das erste anzutreibende Element in eine Bewegung versetzen, so dass ein unabhängiger Antrieb des ersten anzutreibenden Elements und des zweiten anzutreibenden Elements ermöglicht ist.

Hierbei kann es von Vorteil sein, dass die Wellenlänge der ersten akustischen Stehwelle und der zweiten akustischen Stehwelle gleich sind. Dies macht die elektrische Ansteuerung des Ultraschallaktors besonders einfach.

Weiterhin kann es von Vorteil sein, dass zwischen der ersten akustischen Stehwelle und der zweiten akustischen Stehwelle eine Phasenverschiebung von einem Viertel der Wellenlänge besteht. Dadurch ist ein besonders effektiver unabhängiger Antrieb des ersten anzutreibenden Elements und des zweiten anzutreibenden Elements möglich.

Im Folgenden werden Ausführungsformen anhand der beiliegenden Figuren erläutert, die zeigen:
Fig. 1: Explosionsdarstellung eines erfindungsgemäßen Ultraschallmotors ohne elektrische Erregervorrichtung;
Fig. 2: Darstellung 23: Seitenansicht des Ultraschallaktors gemäß Fig. 1; Darstellung 24: Draufsicht auf die Unterseite des Ultraschallaktors gemäß Darstellung 23; Darstellung 25: Draufsicht auf die Oberseite des Ultraschallaktors gemäß Darstellung 23;
Fig. 3: Blockschaltbild betreffend die elektrische Verbindung eines erfindungsgemäßen Ultraschallaktors mit der elektrischen Erregervorrichtung;
Fig. 4: Darstellungen 31-34: Mögliche Varianten zum Verbinden der Erregerelektroden mit der elektrischen Erregervorrichtung (elektrische Erregervorrichtung nicht dargestellt);
Fig. 5: Darstellung 36: Modellierter Ultraschallaktor im unangeregten Zustand; Darstellungen 35 und 37: Berechnete maximale Deformationen des Ultraschallaktors gemäß Darstellung 36 im zur Ausbildung einer Stehwelle angeregten Zustand;
Fig. 6: Vergrößerter Ausschnitt der Darstellung 31 von Fig. 4 zur Verdeutlichung der Bewegung der Punkte der Friktionselemente eines Ultraschallaktors eines erfindungsgemäßen Ultraschallmotors;
Fig. 7: Eine Ausführungsform des erfindungsgemäßen Ultraschallmotors;
Fig. 8: Weitere Ausführungsform des erfindungsgemäßen Ultraschallmotors;

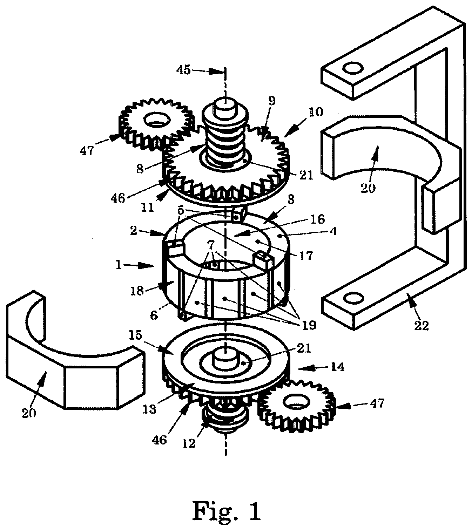

Fig. 1 zeigt einen erfindungsgemäßen Ultraschallmotor in Explosionsdarstellung. Dieser weist einen Ultraschallaktor 1 mit geschlossenem Resonator 2 für eine akustische Deformations-Stehwelle auf, der als piezoelektrischer Hohlzylinder oder Ring 3 ausgeführt ist. Auf einer ersten Stirnfläche 4 der Stirnflächen 4, 6 des piezoelektrischen Hohlzylinders 3 des Aktors 1 ist eine erste Gruppe mit drei Friktionselementen 5 angeordnet. Auf einer zweiten der ersten Stirnfläche 4 gegenüberliegenden Stirnfläche 6 des piezoelektrischen Hohlzylinders 3 ist eine zweite Gruppe mit drei Friktionselementen 7 angeordnet.

An die erste Gruppe von Friktionselementen 5 ist mit Hilfe der Feder 8 das erste anzutreibende Element 9, ausgeführt als Rotor 10 mit einer daran angeordneten Friktionsschicht 11, angepresst. Das anzutreibende Element 9 ist hierbei ein Zahnrad 46, welches seinerseits mit dem Zahnrad 47 in Wirkverbindung steht.

An die zweite Gruppe von Friktionselementen 6 ist mit Hilfe der Feder 12 das zweite anzutreibende Element 13, ausgeführt als Rotor 14 mit einer daran angeordneten Friktionsschicht 15, angepresst. Das anzutreibende Element 13 ist hierbei ebenfalls ein Zahnrad 46, welches ebenso mit einem weiteren Zahnrad 47 in Wirkverbindung steht.

Die Mittelachse des ersten anzutreibenden Elements und die Mittelachse des zweiten anzutreibenden Elements fallen zusammen und liegen auf der Rotationsachse 45, die gleichzeitig die Mittelachse des Ultraschallaktors ist.

Auf der inneren Umfangsfläche 16 des piezoelektrischen Hohlzylinders 3 befindet sich die allgemeine Elektrode 17. Auf der äußeren Umfangsfläche 18 des piezoelektrischen Hohlzylinders 3 befinden sich strukturierte und voneinander getrennte Erregerelektroden 19. Die piezoelektrische Keramik, aus der der piezoelektrische Hohlzylinder 3 gefertigt ist, ist normal zu den Elektroden 17 und 19 polarisiert.

Der Aktor 1 ist durch den Träger 20 gehalten. Die Rotoren 10 und 14 sind beweglich in den Lagern 21 angeordnet bzw. gelagert und werden durch den Träger 22 gehalten.

Die Träger 20 und 22 können Teil des Gehäuses des Ultraschallmotors sein.

Neben den in Fig. 1 dargestellten jeweils drei Friktionselementen pro Stirnfläche kann der Ultraschallaktor 1 auch zwei, vier, fünf oder allgemein n (n =natürliche Zahl) Friktionselemente 5 und 7 auf jeder der Stirnflächen 4 und 6 des piezoelektrischen Hohlzylinders 3 aufweisen.

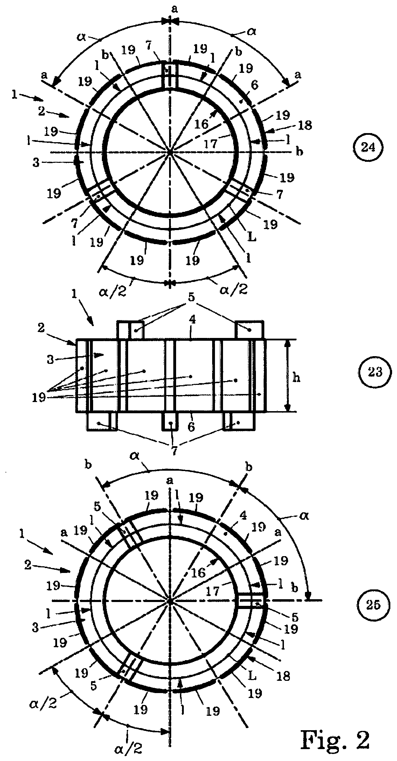

Darstellung 23 von Fig. 2 zeigt den Ultraschallaktor gemäß Fig. 1 in Seitenansicht, während Darstellung 24 eine Draufsicht auf die zweite Stirnfläche 6, also die entsprechende Ansicht "von unten" (d. h. auf die Unterseite) und Darstellung 25 eine Draufsicht auf die erste Stirnfläche 4, also die entsprechende Ansicht "von oben" (d. h. auf die Oberseite) zeigt. Auf der oberen Stirnfläche 4 des Ultraschallaktors sind drei Friktionselemente 5 angeordnet, wobei der Abstand zwischen zwei benachbarten Friktionselementen jeweils 2a beträgt. In analoger Weise sind auf der unteren Stirnfläche 6 ebenfalls drei Friktionselemente 7 angeordnet, wobei der Abstand zwischen zwei benachbarten Friktionselementen auch jeweils 2a beträgt.

Die Stirnfläche 6 des Ultraschallaktors 1 ist durch die virtuellen Linien a in sechs gleiche Teilflächen (allgemein in eine gerade Zahl gleicher Teilflächen) geteilt, wobei der Winkel • zwischen benachbarten Linien a gleich ist. In analoger Weise ist die Stirnfläche 4 des Ultraschallaktors 1 durch die virtuellen Linien b in sechs gleiche Teilflächen (allgemein in eine gerade Zahl gleicher Teilflächen) geteilt, wobei der Winkel • zwischen benachbarten Linien b ebenfalls gleich ist. Die Linien a und b liegen hierbei nicht aufeinander, sondern zwischen jeweils benachbarten Linien a und b liegt der Winkel • /2.

Jede der Linien a bildet die Symmetrieachse für eines der Friktionselemente 7, während jede der Linien b die Symmetrieachse für eines der Friktionselemente 5 bildet.

Der piezoelektrische Hohlzylinder 4 hat einen mittleren Umfang L und eine Höhe h. Der mittlere Umfang L wird durch die Linien a und b in sechs gleiche Abschnitte l (allgemein in eine gerade Zahl gleicher Abschnitte) geteilt. Der mittlere Umfang L ist der Umfang des Hohlzylinders an der Stelle, welche die Mitte zwischen der Außen- und der Innenumfangsfläche definiert.

Jeder der Abschnitte l wird durch die Linien a und b in zwei Hälften geteilt.

Es ist besonders vorteilhaft, wenn das Verhältnis von l/h im Bereich zwischen 0,9 und 1,3 liegt.

Auf jedem durch zwei benachbarte Linien a und b abgetrennten Teilumfang des Ultrachallaktors bzw. auf der entsprechenden äußeren Teilumfangsfläche ist eine Erregerelektrode 19 angeordnet. Mit anderen Worten erstreckt sich jeder Erregerelektrode am Außenumfang über einen Winkel von im Wesentlichen • /2 (zwischen benachbarten Erregerelektroden ist ein Spalt, der die Elektroden voneinander trennt).

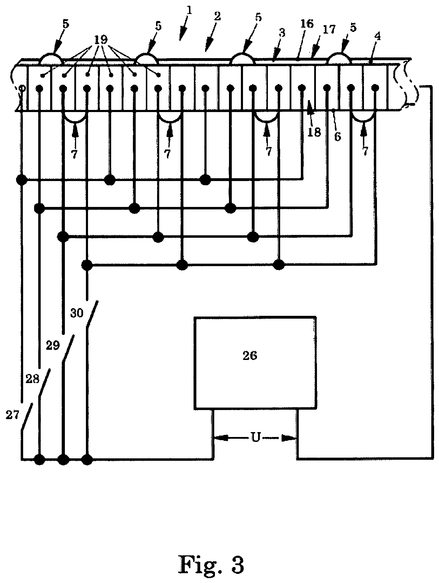

Fig. 3 zeigt unter Verwendung eines abgewickelten Ultraschallaktors 1 mit vier Friktionselementen 5 und mit vier Friktionselementen 7 ein Blockschaltbild betreffend die elektrische Verbindung der Elektroden 17 und 19 mit der elektrischen Erregervorrichtung 26.

Die elektrische Erregervorrichtung 26 stellt hierbei die elektrische Wechselspannung U bereit, deren Frequenz fa gleich der Arbeitsfrequenz des Aktors 1 ist.

Die Frequenz fa kann aus der Formel fa = N/l bestimmt werden, wobei N die Frequenzkonstante der Piezokeramik ist, die sowohl vom Typ der im Aktor erzeugten akustischen Stehwelle als auch von der Piezokeramik, aus der der piezoelektrische Hohlzylinder 3 gefertigt ist, abhängt.

Die elektrische Schaltung zum Verbinden der Elektroden 17 und 19 mit der elektrischen Erregervorrichtung 26 weist die Umschalter 27, 28, 29 und 30 auf, mit deren Hilfe die Elektroden 19 paarweise mit der elektrischen Erregervorrichtung 26 des Aktors 1 verbunden werden.

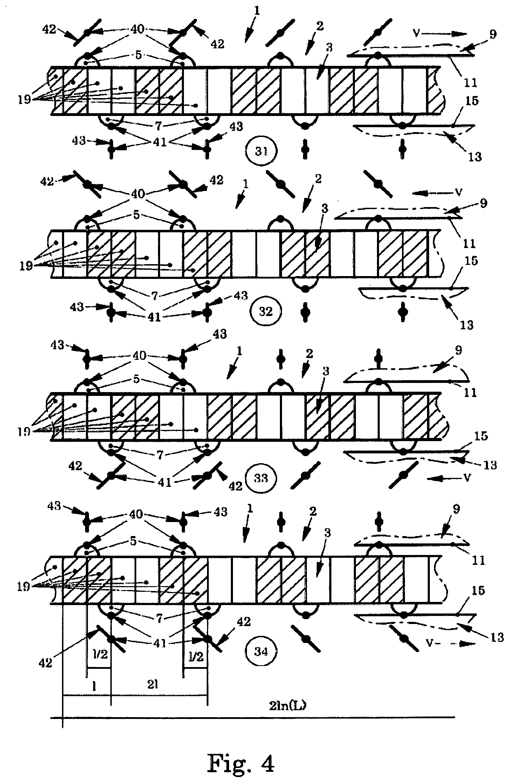

Die Darstellungen 31 bis 34 von Fig. 4 zeigen vier mögliche Varianten zum Verbinden der Elektroden 19 mit der elektrischen Erregervorrichtung 26. Im ersten Fall gemäß Darstellung 31 sind die Umschalter 27 und 28 geschlossen. Im zweiten Fall gemäß Darstellung 32 sind die Umschalter 29 und 30 geschlossen. Im dritten Fall gemäß Darstellung 33 sind die Umschalter 27 und 30 geschlossen, während im vierten Fall gemäß Darstellung 34 sind die Umschalter 28 und 29 geschlossen sind. Die Verbindung der Elektroden 19 mit der elektrischen Erregervorrichtung ist mit Strichen dargestellt.

In allen oben aufgeführten Fällen bildet jedes Paar von Erregerelektrode 19 und allgemeiner Elektrode 17 und der Piezokeramik zwischen ihnen einen Generator für eine akustische Deformationsstehwelle. Neben der hier aufgezeigten Dreischichtstruktur können die Generatoren für die akustische Stehwelle eine Vielschichtstruktur aufweisen, wobei die Schichten der allgemeinen Elektroden 17, die Schichten der Erregerelektroden 19 und die Piezokeramikschichten abwechselnd angeordnet sind.

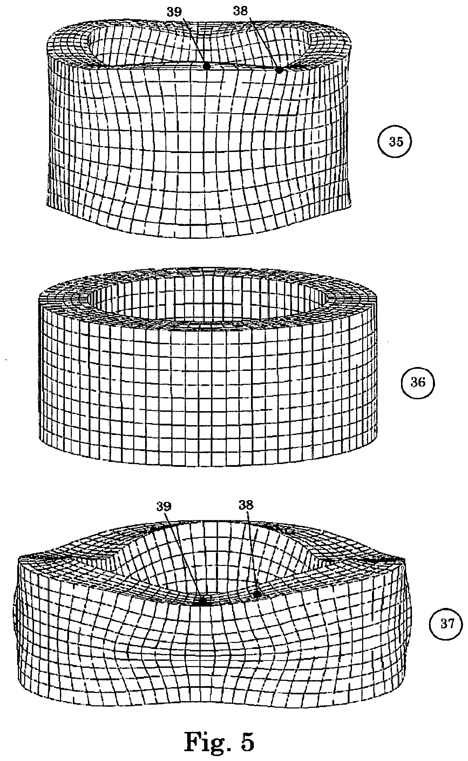

Beim Anlegen der elektrischen Spannung U mit der Frequenz fa an die in den Darstellungen 31 bis 34 von Fig. 4 schraffierten Generatoren wird im Aktor 1 eine akustische Deformationsstehwelle erzeugt. Die Darstellungen 35 bis 37 von Fig. 5 verdeutlichen anhand von FEM-Berechnungen die Form dieser Welle.

Die Länge der im Aktor erzeugten Welle • beträgt L/n oder 2l, d. h. die Länge des mittleren Umfangs L des piezoelektrischen Hohlzylinders 3 beträgt 2ln oder • n. Der Abstand zwischen zwei benachbarten Friktionselementen 5 und 7 ist gleich einem Viertel der Wellenlänge • /4 oder l/2. Die Breite jeder Erregerelektrode 19 ist gleich einem Viertel der Wellenlänge • /4 d. h. l/2.

Bei der im Ultraschallaktor 1 erzeugten Welle treten in den Punkten 38 die maximale Amplitude für die Längskomponente der Schwingungen und die maximale Amplitude für die Querkomponente der Schwingungen auf. In den Punkten 39 weist die Welle nur eine Querkomponente der Schwingungen auf.

Im Falle, dass der piezoelektrische Hohlzylinder 3 aus der Piezokeramik PIC 181 der Firma Pl Ceramic GmbH gefertigt wurde und im Ultraschallaktor 1 die in Fig. 5 dargestellte Welle erzeugt wird, beträgt die Frequenzkonstante N 1837 Hzm.

Beim Betätigen der Umschalter 27 bis 30 gemäß den Darstellungen 31 bis 34 von Fig. 4 ändert sich die Form der erzeugten Stehwelle nicht. Es ändert sich nur die Lage der Welle bezogen zu den Friktionselementen 5 und 7. Die Welle ist um die Hälfte ihrer Wellenlänge • /2 (I) oder um ein Viertel ihrer Wellenlänge • /4 (I) verschoben.

Die Lageänderung der Welle führt zu einer Änderung der Bewegungsbahnen der auf den Stirnflächen der Oberflächen 4 und 6 bzw. der auf den Friktionselementen des piezoelektrischen Hohlzylinders 3 angeordneten Punkte. Dies führt dazu, dass die Punkte 35 und 36 auf den Friktionselementen 5 und 7 ihre Bewegungsbahnen ändern, gezeigt in den Darstellungen 31 bis 34 von Fig. 4. In jedem dargestellten Fall bewegen sich die Punkte 40 und 41 auf zwei unterschiedlichen Bewegungsbahnen: auf einer geneigten Bewegungsbahn 42 und auf einer Querbewegungsbahn 43.

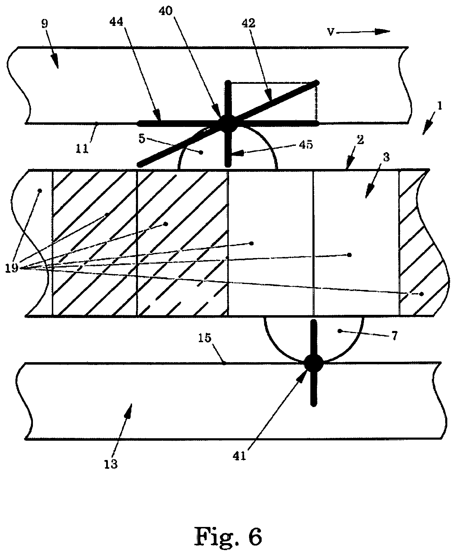

Fig. 6 ist eine vergrößerte Darstellung der Bewegung der Punkte 40 der Friktionselemente 5 und der Punkte 41 der Friktionselemente 7 für den in Darstellung 31 von Fig. 4 gezeigten Fall.

Die Neigung der Bewegungsbahn 42 der Punkte 40 kann in zwei Bewegungsbestandteile zerlegt werden: einen Längsbestandteil 44 und einen Querbestandteil 45. Der Querbestandteil 45 hat zur Folge, dass jedes Friktionselement 5 an die Friktionsschicht 11 des ersten anzutreibenden Elements 9 angepresst wird und der Längsbestandteil 44 bewirkt, dass das Friktionselement 5 auf Grund der Reibung des Längsbestandteils 44 eine Bewegung des ersten anzutreibenden Elements 9 hervorruft.

Da sich die Punkte 41 auf Querbewegungsbahnen 43, die keine Längskomponente enthalten bewegen, befindet sich das zweite anzutreibende Element 13 im unbewegten Zustand.

Die Änderung der Bewegungsrichtung erfolgt durch Umkehr der Neigung der Bewegungsbahn 42.

In Fig. 4 ist die Bewegungsrichtung der anzutreibenden Elemente 9 und 13 mit Pfeilen und dem Index V gekennzeichnet.

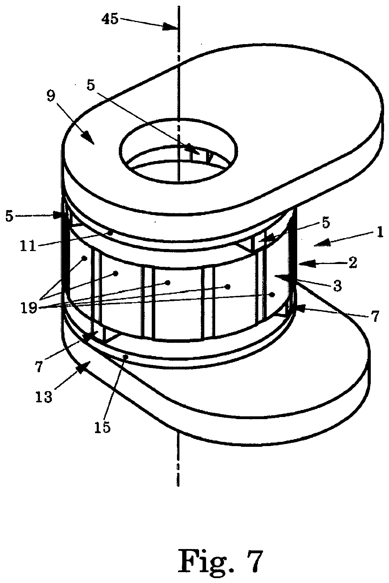

Fig. 7 zeigt einen erfindungsgemäßen Ultraschallmotor, bei dem das Massezentrum des ersten anzutreibenden Elements 9 und das Massezentrum des zweiten beweglichen Elements 13 nicht mit ihren Rotationsachsen 45 zusammenfallen. Ein solcher Ultraschallmotor kann zum automatischen Ausbalancieren von Schleifscheiben oder ähnlichen schnell rotierenden Instrumenten und Werkzeugen verwendet werden.

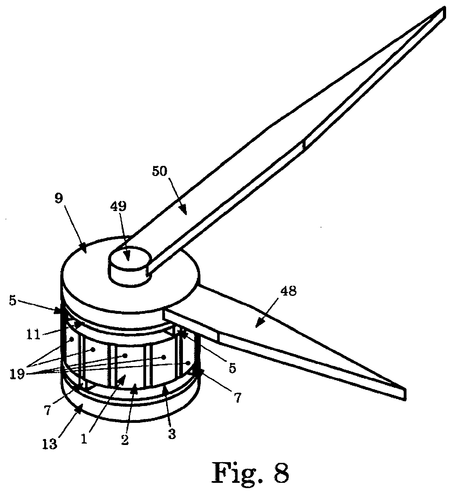

Fig. 8 zeigt einen Ultraschallmotor, bei dem das erste anzutreibende Element 9 mit einem Zeiger 48 ausgestattet ist und das zweite anzutreibende Element 13 über eine Welle 49 mit dem Zeiger 50 verbunden ist. Dieser Ultraschallmotor kann in Messgeräten von Fahrzeugen, in Uhrwerken oder in anderen Messeinrichtungen eingesetzt werden, bei denen eine unabhängige Verschiebung von zwei Zeigereinheiten erforderlich ist.

Durch den erfindungsgemäßen Ultraschallmotor und das entsprechende Verfahren zum Betreiben eines solchen Ultraschallmotors ist es anhand nur eines einzigen Ultraschallaktors möglich, zwei anzutreibende Elemente unabhängig voneinander in Bewegung zu versetzen, und dabei auch die Bewegungsrichtung zu ändern oder sie im gebremsten Zustand anzuhalten. Dies erweitert das Einsatzgebiet für Ultraschallmotoren bzw. -antriebe deutlich.

## Patentansprüche

1. Ultraschallmotor, aufweisend einen hohlzylindrischen oder ringförmigen Ultraschallaktor (1) aus einem piezoelektrischen Material, an dessen einer ebenen Stirnfläche (4) eine erste Gruppe von Friktionselementen (5) angeordnet ist, wobei die Friktionselemente (5) der ersten Gruppe jeweils um einen ersten Umfangswinkel voneinander beabstandet sind und mit einem ersten anzutreibenden Element (9) in Friktionskontakt stehen, und an dessen anderer ebenen Stirnfläche (6) eine zweite Gruppe von Friktionselementen (7) angeordnet ist, wobei die Friktionselemente (7) der zweiten Gruppe jeweils um einen zweiten Umfangswinkel voneinander beabstandet sind und mit einem zweiten anzutreibenden Element (13) in Friktionskontakt stehen,
**dadurch gekennzeichnet,**
**dass** an der Innenumfangsfläche (16) des Ultraschallaktors (1) eine allgemeine Elektrode (17) angeordnet ist und an der Außenumfangsfläche (18) des Ultraschallaktors (1) strukturierte und voneinander getrennte Erregerelektroden (19) angeordnet sind,
**dass** jede Erregerelektrode (19) mit der allgemeinen Elektrode (17) und dem zwischen ihnen angeordneten piezoelektrischen Material (3,4) einen Generator für eine akustische Stehwelle ausbildet, und die Generatoren derart konzipiert sind, dass sie mit einer elektrischen Spannung beaufschlagt werden, um in dem Ultraschallaktor (1) eine akustische Stehwelle zu erzeugen, wobei die Friktionselemente (5) der ersten Gruppe um einen dritten Umfangswinkel versetzt zu den Friktionselementen (7) der zweiten Gruppe angeordnet sind, wobei der dritte Umfangswinkel kleiner als der erste Umfangswinkel und kleiner als der zweite Umfangswinkel ist.

2. Ultraschallmotor nach Anspruch 1, **dadurch gekennzeichnet, dass** der erste Umfangswinkel dem zweiten Umfangswinkel entspricht.

3. Ultraschallmotor nach Anspruch 1 oder 2, **dadurch gekennzeichnet, dass** der dritte Umfangswinkel einem Viertel des ersten Umfangswinkels oder einem Viertel des zweiten Umfangswinkels entspricht.

4. Ultraschallmotor nach einem der vorhergehenden Ansprüche, **dadurch gekennzeichnet, dass** die Generatoren jeweils eine Vielzahl von sich abwechselnden Schichten von Erregerelektroden (19) und allgemeinen Elektroden (17) aufweisen, wobei zwischen zwei benachbarten Elektrodenschichten (17, 19) eines Generators eine Schicht piezoelektrischen Materials angeordnet ist.

5. Ultraschallmotor nach einem der vorhergehenden Ansprüche, **dadurch gekennzeichnet, dass** sowohl das erste anzutreibende Element (9), als auch das zweite anzutreibende Element (13) derart konzipiert sind, dass sie in eine rotative Bewegung versetzt werden und der Masseschwerpunkt des ersten anzutreibenden Elements (9) und des zweiten anzutreibenden Elements (13) mit der jeweiligen Rotationsachse (45) zusammenfällt.

6. Verfahren zum Betreiben des Ultraschallmotors nach einem der vorhergehenden Ansprüche, **gekennzeichnet durch** das Anlegen einer elektrischen Spannung an die Elektroden (17, 19) der Generatoren zur Erzeugung einer ersten akustischen Stehwelle mit longitudinaler und transversaler Schwingungskomponente in dem Ultraschallaktor (1), wobei die erste akustische Stehwelle derart ausgebildet ist, dass nur die Friktionselemente (5) der ersten Gruppe das erste anzutreibende Element (9) in eine Bewegung versetzen und ohne dass die Friktionselemente (7) der zweiten Gruppe das zweite anzutreibende Element (13) in eine Bewegung versetzen, oder Anlegen einer elektrischen Spannung an die Elektroden (17, 19) der Generatoren zur Erzeugung einer zweiten akustischen Stehwelle mit longitudinaler und transversaler Schwingungskomponente in dem Ultraschallaktor, wobei die zweite akustische Stehwelle derart ausgebildet ist, dass nur die Friktionselemente (7) der zweiten Gruppe das zweite anzutreibende Element (13) in eine Bewegung versetzen und ohne dass die Friktionselemente (5) der ersten Gruppe das erste anzutreibende Element (9) in eine Bewegung versetzen, so dass ein unabhängiger Antrieb des ersten anzutreibenden Elements (9) und des zweiten anzutreibenden Elements (13) ermöglicht ist.

7. Verfahren nach Anspruch 6, **dadurch gekennzeichnet, dass** die Wellenlänge der ersten akustischen Stehwelle und der zweiten akustischen Stehwelle gleich ist.

8. Verfahren nach Anspruch 7, **dadurch gekennzeichnet, dass** zwischen der ersten akustischen Stehwelle und der zweiten akustischen Stehwelle eine Phasenverschiebung von einem Viertel der Wellenlänge besteht.

## Claims

1. Ultrasonic motor, comprising a hollow cylindrical or annular ultrasonic actuator (1) made of a piezoelectric material with a flat end face (4) at which a first group of friction elements (5) is disposed, wherein the friction elements (5) of the first group are spaced from each other respectively by a first circumferential angle and are in each case in frictional contact with a first element (9) to be driven, and wherein on the other flat end face (6) of the ultrasonic actuator a second group of friction elements (7) is disposed,
wherein the friction elements (7) of the second group are spaced from each other respectively by a second circumferential angle and are in each case in frictional contact with a second element (13) to be driven,
**characterized in that**
on the inner circumferential surface (16) of the ultrasonic actuator (1) a common electrode (17) is disposed and on the outer peripheral surface (18) of the ultrasonic actuator (1) structured and mutually separate excitation electrodes (19) are disposed,
each excitation electrode (19) with the common electrode (17) and the piezoelectric material (3, 4) disposed between them form a generator for an acoustic standing wave and the generators are designed such that an electrical voltage is applied to the same in order to generate an acoustic standing wave in the ultrasonic actuator (1), wherein the friction elements (5) of the first group are disposed offset to the friction elements (7) of the second group by a third circumferential angle, wherein the third circumferential angle is smaller than the first circumferential angle and smaller than the second circumferential angle.

2. Ultrasonic motor according to claim 1, **characterized in that** the first circumferential angle corresponds to the second circumferential angle.

3. Ultrasonic motor according to claim 1 or 2, **characterized in that** the third circumferential angle corresponds to a quarter of the first circumferential angle or to a quarter of the second circumferential angle.

4. Ultrasonic motor according to one of the preceding claims, **characterized in that** the generators each comprise a plurality of alternating layers of excitation electrodes (19) and general electrodes (17), wherein between two adjacent electrode layers (17, 19) of a generator a layer made of piezoelectric material is disposed.

5. Ultrasonic motor according to one of the preceding claims, **characterized in that** both the first element (9) to be driven and the second element (13) to be driven are designed such that they are set in a rotational movement, and the center of mass of the first element (9) to be driven and of the second element (13) to be driven coincides with the respective axis of rotation (45).

6. Method for operating the ultrasonic motor according to one of the preceding claims, **characterized by** the application of an electrical voltage to the electrodes (17, 19) of the generators for generation of a first acoustic standing wave with longitudinal and transversal vibration component in the ultrasonic actuator (1), wherein the first acoustic standing wave is formed such that only the friction elements (5) of the first group actuates the first element (9) to be driven, wherein the friction elements (7) of the second group do not actuate the second element (13) to be driven, or by applying an electrical voltage to the electrodes (17, 19) of the generators for generation of a second acoustic standing wave with longitudinal and transversal vibration component in the ultrasonic actuator, wherein the second acoustic standing wave is formed such that only the friction elements (7) of the second group actuate the second element (13) to be driven, wherein the friction elements (5) of the first group do not actuate the first element (9) to be driven, so that an independent drive of the first element (9) to be driven and the second element (13) to be driven is made possible.

7. The method according to claim 6, **characterized in that** the wavelength of the first acoustic standing wave and the second acoustic standing wave is the same.

8. The method according to claim 7, **characterized in that** between the first acoustic standing wave and the second acoustic standing wave a phase shift of one quarter of the wavelength exists.

## Revendications

1. Moteur à ultrasons, comprenant un actionneur à ultrasons (1) en forme d'un cylindre creux ou en forme annulaire, fait d'un matériau piézoélectrique avec une face frontale plane (4), à laquelle un premier groupe d'éléments de friction (5) est arrangé, les éléments de friction (5) du premier groupe étant respectivement espacés les uns des autres par un premier angle circonférentiel et étant à chaque cas en contact de friction avec un premier élément (9) à entraîner, et un deuxième groupe d'éléments de friction (7) étant arrangé à l'autre face frontale plane (6) de l'actionneur, les éléments de friction (7) du deuxième groupe étant respectivement espacés les uns des autres par un deuxième angle circonférentiel et étant en contact de friction avec un deuxième élément (13) à entraîner,
**caractérisé en ce que**
une électrode générale (17) est arrangée à la surface circonférentielle intérieure (16) de l'actionneur à ultrasons (1) et des électrodes d'excitation (19) structurées et séparées les unes des autres sont arrangées à la surface circonférentielle extérieure (18) de l'actionneur à ultrasons (1),
chaque électrode d'excitation (19) forme avec l'électrode générale (17) et le matériau piézoélectrique (3, 4) arrangé entre celles-ci un générateur pour une onde acoustique stationnaire, et que les générateurs sont adaptés de sorte qu'une tension électrique est appliquée à ceux-ci pour générer une onde acoustique stationnaire dans l'actionneur à ultrasons (1), les éléments de friction (5) du premier groupe étant arrangés de manière décalée par rapport aux éléments de friction (7) du deuxième groupe selon un troisième angle circonférentiel, le troisième angle circonférentiel étant plus petit que le premier angle circonférentiel et plus petit que le deuxième angle circonférentiel.

2. Moteur à ultrasons selon la revendication 1, **caractérisé en ce que** le premier angle circonférentiel correspond au deuxième angle circonférentiel.

3. Moteur à ultrasons selon les revendications 1 ou 2, **caractérisé en ce que** le troisième angle circonférentiel correspond à un quart du premier angle circonférentiel ou un quart du deuxième angle circonférentiel.

4. Moteur à ultrasons selon une des revendications précédentes, **caractérisé en ce que** les générateurs comprennent respectivement une pluralité de couches d'électrodes d'excitation (19) et d'électrodes générales (17) en alternance, une couche de matériau piézoélectrique étant arrangée entre deux couches d'électrodes (17, 19) adjacentes d'un générateur.

5. Moteur à ultrasons selon une des revendications précédentes, **caractérisé en ce que** le premier élément (9) à entraîner tout comme le deuxième élément (13) à entraîner sont adaptés de sorte qu'ils sont mis en un mouvement rotatif et que le centre de gravité du premier élément (9) à entraîner et du deuxième élément (13) à entraîner correspond à l'axe de rotation (45) respectif.

6. Procédé pour faire fonctionner le moteur à ultrasons selon une des revendications précédentes, **caractérisé par** l'application d'une tension électrique aux électrodes (17, 19) des générateurs pour générer une première onde acoustique stationnaire avec des composantes de vibration transversale et longitudinale dans l'actionneur à ultrasons (1), la première onde acoustique stationnaire étant adaptée de sorte que seulement les éléments de friction (5) du premier groupe mettent en mouvement le premier élément (9) à entraîner et sans que les éléments de friction (7) du deuxième groupe mettent en mouvement le deuxième élément (13) à entraîner, ou par l'application d'une tension électrique aux électrodes (17, 19) des générateurs pour générer une deuxième onde acoustique stationnaire avec des composantes de vibration transversale et longitudinale dans l'actionneur à ultrasons, la deuxième onde acoustique stationnaire étant adaptée de sorte que seulement les éléments de friction (7) du deuxième groupe mettent en mouvement le deuxième élément (13) à entraîner sans que les éléments de friction (5) du premier groupe mettent en mouvement le premier élément (9) à entraîner, de sorte qu'un entraînement indépendant du premier élément (9) à entraîner et du deuxième élément (13) à entraîner est rendu possible.

7. Procédé selon la revendication 6, **caractérisé en ce que** la longueur d'onde de la première onde acoustique stationnaire est égale à la longueur d'onde de la deuxième onde acoustique stationnaire.

8. Procédé selon la revendication 7, **caractérisé en ce qu'**il y a entre la première onde acoustique stationnaire et la deuxième onde acoustique stationnaire un déphasage d'un quart de la longueur d'onde.
